# EUROPEAN PATENT APPLICATION

(11) **EP 4 697 611 A1**
(43) Date of publication of application: **18.02.2026**
(21) Application number: 25178079.7
(22) Date of filing: 21.05.2025
(51) Int. Cl.: H04B 1/525

(54) **TRANSCEIVER AND SEMICONDUCTOR CHIP WITH LOW NOISE CHARACTERISTICS, AND ELECTRONIC DEVICE INCLUDING THE SAME**

(30) Priority: 14.08.2024 KR 20240109300
(71) Applicant: Samsung Electronics Co., Ltd., Suwon-si, Gyeonggi-do 16677 (KR)
(72) Inventor: JUNG, Wonjun, 16677 Suwon-si (KR); KIM, Sinyoung, 16677 Suwon-si (KR); KIM, Wan, 16677 Suwon-si (KR); SEOK, Hyungi, 16677 Suwon-si (KR)
(74) Representative: Marks & Clerk LLP

(57) **Abstract**

A transceiver includes a first mixer, a noise reduction circuit, a first amplifier, a second amplifier and an input/output (I/O) port. The first mixer receives first data and a first clock signal, and generates a first signal to be transmitted to an external device based on the first data and the first clock signal. The noise reduction circuit provides the first clock signal to the first mixer. The first amplifier amplifies the first signal received from the first mixer. The second amplifier amplifies a second signal received from the external device. The I/O port is shared by the first amplifier and the second amplifier, and is configured to output the amplified first signal and receive the second signal. The noise reduction circuit activates the first clock signal during an activation time interval for the first data, and deactivates the first clock signal during a deactivation time interval for the first data.

## Description

### BACKGROUND

### 1. Technical Field

Example embodiments relate generally to semiconductor integrated circuits, and more particularly to transceivers and semiconductor chips with low noise characteristics, and electronic devices including the transceivers and/or the semiconductor chips.

### 2. Description of the Related Art

With the increase in package price, the chip size of a radio frequency integrated circuit (RFIC) for wireless mobile communication has been increasingly reduced. In addition, it is beneficial for RFICs for wireless mobile communication to produce a desired output with low power. Recently, as mobile communication has evolved from third-generation (3G) to long-term evolution (LTE) to fifth-generation (5G), RFICs for wireless mobile communications are increasingly required to support modulations such as radio detecting and ranging (RADAR), and their operating frequencies are also increasing. However, there are problems in the design of an impedance matching network of RFICs for wireless mobile communications, and in the design of RFICs for wireless mobile communications with low noise characteristics.

### SUMMARY

At least one example embodiment of the present disclosure provides a transceiver and a semiconductor chip capable of having low noise characteristics by preventing a signal from a transmitter from transferring to a receiver.

At least one example embodiment of the present disclosure provides an electronic device including the transceiver and/or the semiconductor chip.

According to example embodiments, a transceiver includes a first mixer, a noise reduction circuit, a first amplifier, a second amplifier and an input/output (I/O) port. The first mixer receives first data and a first clock signal, and generates a first signal to be transmitted to an external device based on the first data and the first clock signal. The noise reduction circuit provides the first clock signal to the first mixer. The first amplifier amplifies the first signal received from the first mixer. The second amplifier amplifies a second signal received from the external device. The I/O port is shared by the first amplifier and the second amplifier, and is configured to output the amplified first signal and receive the second signal. The noise reduction circuit activates the first clock signal during an activation time interval for the first data, and deactivates the first clock signal during a deactivation time interval for the first data.

According to example embodiments, a transceiver includes a first mixer, a first amplifier, a second amplifier, an input/output (I/O) port, a switch circuit and a noise reduction circuit. The first mixer receives first data and a first clock signal, and generates a first signal to be transmitted to an external device based on the first data and the first clock signal. The first amplifier amplifies the first signal received from the first mixer. The second amplifier amplifies a second signal received from the external device. The I/O port is shared by the first amplifier and the second amplifier, and is configured to output the amplified first signal and receive the second signal. The switch circuit is disposed between the first amplifier and the I/O port, and is turned on and off based on a switch control signal. The noise reduction circuit provides the switch control signal to the switch circuit. The noise reduction circuit is configured to output the switch control signal to have an active state during an activation time interval for the first data, and to output the switch control signal to have a deactivated state during a deactivation time interval for the first data.

According to example embodiments, a semiconductor chip includes a processor and a transceiver. The processor generates first data to be transmitted to an external device. The transceiver receives the first data, and operates based on the first data. The transceiver includes a first mixer, a noise reduction circuit, a first amplifier, a second amplifier and an input/output (I/O) port. The first mixer generates a first signal based on the first data and the first clock signal. The noise reduction circuit provides the first clock signal to the first mixer. The first amplifier amplifies the first signal received from the first mixer. The second amplifier amplifies a second signal received from the external device. The I/O port is shared by the first amplifier and the second amplifier, and is configured to output the amplified first signal and receive the second signal. The noise reduction circuit activates the first clock signal during an activation time interval for the first data, and deactivates the first clock signal during a deactivation time interval for the first data.

According to example embodiments, a semiconductor chip includes a processor and a transceiver. The processor generates first data to be transmitted to an external device. The transceiver receives the first data, and operates based on the first data. The transceiver includes a first mixer, a first amplifier, a second amplifier, an input/output (I/O) port, a switch circuit and a noise reduction circuit. The first mixer generates a first signal based on the first data and a first clock signal. The first amplifier amplifies the first signal received from the first mixer. The second amplifier amplifies a second signal received from the external device. The I/O port is shared by the first amplifier and the second amplifier, and is configured to output the amplified first signal and receive the second signal. The switch circuit is disposed between the first amplifier and the I/O port, and is turned on and off based on a switch control signal. The noise reduction circuit provides the switch control signal to the switch circuit. The noise reduction circuit is configured to control the switch control signal to be in an active state during an activation time interval for the first data, and to control the switch control signal to be in an inactive state during a deactivation time interval for the first data.

According to example embodiments, an electronic device includes an antenna, a processor and a transceiver. The antenna transmits a first signal to an external device or receives a second signal from the external device. The processor generates first data corresponding to the first signal, generates an enable signal, and receives second data corresponding to the second signal. The enable signal is activated during an activation time interval for the first data and is deactivated during a deactivation time interval for the first data. The transceiver generates the first signal based on the first data and the enable signal, and generates the second data based on the second signal. The transceiver includes a noise reduction circuit, a first mixer, a power amplifier, a low noise amplifier, a second mixer, an input/output (I/O) port and a switch circuit. The noise reduction circuit generates a first clock signal based on the enable signal and a second clock signal, and generates a switch control signal based on the enable signal. The first mixer generates the first signal based on the first data and the first clock signal. The power amplifier amplifies the first signal. The low noise amplifier amplifies the second signal. The second mixer generates the second data based on the amplified second signal and the second clock signal. The I/O port is shared by the first amplifier and the second amplifier, and is connected to the antenna. The switch circuit is disposed between the first amplifier and the I/O port, and is turned on and off based on the switch control signal.

In the transceiver, the semiconductor chip and the electronic device according to example embodiments, the I/O port may be shared by the transmitter and the receiver, and the noise reduction circuit that generates the noise reduction control signal in synchronization with the first data may be included. For example, the noise reduction control signal may be generated based on the enable signal. For example, the noise reduction control signal and the enable signal may be activated (e.g., in an active state) during the activation time interval of the first data, and may be deactivated (e.g., in an inactive state) during the deactivation time interval of the first data. For example, at least one of the mixer and the switch circuit included in the transmitter may be selectively turned on and off based on the enable signal. Accordingly, the noise by the transmitter may be efficiently prevented from being transmitted to the receiver, and the transceiver may have relatively improved or enhanced performance.

At least some of the above and other features of the invention are set out in the claims.

### BRIEF DESCRIPTION OF THE DRAWINGS

Illustrative, non-limiting example embodiments will be more clearly understood from the following detailed description taken in conjunction with the accompanying drawings.
FIG. 1 is a block diagram illustrating a transceiver according to example embodiments.
FIG. 2 is a block diagram illustrating an example of a transceiver of FIG. 1.
FIG. 3 is a block diagram illustrating an example of a noise reduction circuit included in a transceiver of FIG. 2.
FIG. 4 is a diagram for describing an operation by a noise reduction circuit of FIG. 3.
FIG. 5 is a block diagram illustrating an example of a noise reduction circuit included in a transceiver of FIG. 2.
FIG. 6 is a block diagram illustrating an example of a transceiver of FIG. 1.
FIG. 7 is a block diagram illustrating an example of a transceiver of FIG. 1.
FIG. 8 is a block diagram illustrating an example of a transceiver of FIG. 1.
FIG. 9 is a block diagram illustrating an example of a noise reduction circuit included in a transceiver of FIG. 8.
FIGS. 10A and 10B are diagrams for describing a noise reduction circuit of FIG. 9.
FIG. 11 is a diagram illustrating an example of a buffer circuit and a switch circuit of FIG. 9.
FIGS. 12, 13 and 14 are diagrams for describing an operation by a noise reduction circuit of FIG. 9, according to an example embodiment.
FIG. 15 is a diagram illustrating an example of a buffer circuit and a switch circuit of FIG. 9.
FIG. 16 is a block diagram illustrating an example of a transceiver of FIG. 1.
FIG. 17 is a block diagram illustrating an example of a transceiver of FIG. 1.
FIG. 18 is a block diagram illustrating an example of a noise reduction circuit included in a transceiver of FIG. 17.
FIG. 19 is a block diagram illustrating a semiconductor chip according to example embodiments.
FIGS. 20 and 21 are flowcharts illustrating a method of transmitting data according to example embodiments.
FIG. 22 is a block diagram illustrating an electronic device in a network environment according to example embodiments.

### DETAILED DESCRIPTION OF THE EMBODIMENTS

Various example embodiments will be described more fully with reference to the accompanying drawings, in which embodiments are shown. The present disclosure may, however, be embodied in many different forms and should not be construed as limited to the embodiments set forth herein. Like reference numerals refer to like elements throughout this application.

Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first") in a particular claim may be described elsewhere with a different ordinal number (e.g., "second") in the specification or another claim.

Components described herein as performing certain functions or steps are configured to perform those functions or steps, based on the hardware, such as circuitry, and in some cases software, included therein.

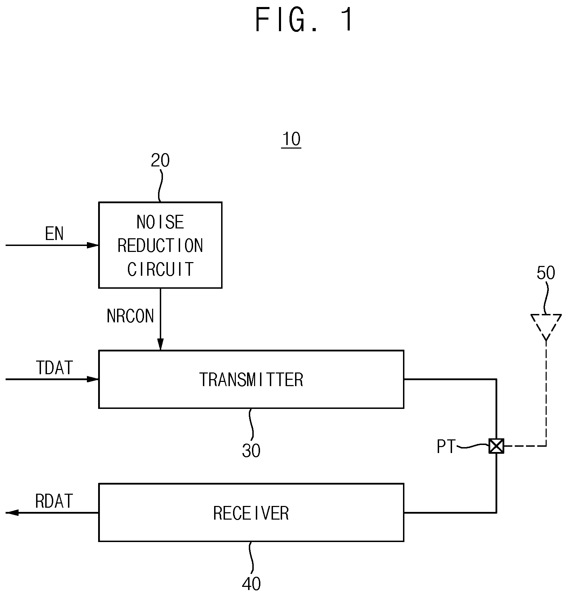

FIG. 1 is a block diagram illustrating a transceiver according to example embodiments.

Referring to FIG. 1, a transceiver 10 includes a noise reduction circuit 20, a transmitter 30, a receiver 40 and an input/output (I/O) port PT.

In some example embodiments, the transceiver 10 may be included in an electronic device (e.g., a communication device). For example, the transceiver 10 may transmit a signal to an external device (e.g., another electronic device and/or another transceiver), and/or may receive a signal from the external device.

In some example embodiments, the transceiver 10 may be implemented as a single integrated circuit (IC). For example, the noise reduction circuit 20, the transmitter 30, the receiver 40 and the I/O port PT that are included in the transceiver 10 may be included in a single semiconductor chip (or a single semiconductor package or module).

The transmitter 30 receives first data TDAT (e.g. a data signal), and generates and outputs a first signal (or transmission signal) by performing data processing and/or signal processing on the first data TDAT. For example, the first data TDAT may be provided from a processor that is located outside the transceiver 10. For example, the first signal may be output externally from the transceiver 10, and may be transmitted to another electronic device and/or another transceiver. The transmitter 30 and/or a path including the transmitter 30 may be referred to as a transmission path.

The receiver 40 receives a second signal (or reception signal), and generates and outputs second data RDAT by performing signal processing and/or data processing on the second signal. For example, the second signal may be provided from another electronic device and/or another transceiver. For example, the second data RDAT may be output externally from the transceiver 10, and may be transmitted to the processor. The receiver 40 and/or a path including the receiver 40 may be referred to as a reception path.

The I/O port PT is connected to the transmitter 30 and the receiver 40, and is shared by the transmitter 30 and the receiver 40. The I/O port PT may be connected to an antenna 50 that is located outside the transceiver 10, and may output the first signal or receive the second signal through the antenna 50.

In some example embodiments, the transceiver 10 may operate in a transmission mode and a reception mode. For example, in the transmission mode, the transmitter 30 may be enabled or activated, may receive the first data TDAT, and may generate and output the first signal, and at this time, the receiver 40 may be disabled or deactivated. For example, in the reception mode, the receiver 40 may be enabled or activated, may receive the second signal, and may generate and output the second data RDAT, and at this time, the transmitter 30 may be disabled or deactivated.

In some example embodiments, the transceiver 10 may operate in an operation mode in which the transmitter 30 and the receiver 40 are enabled or activated together. For example, when the transceiver 10 is included in an electronic device supporting a radio detecting and ranging (RADAR) function, the transceiver 10 for the RADAR function may operate with the transmitter 30 and the receiver 40 that are enabled substantially simultaneously or concurrently.

The noise reduction circuit 20 generates a noise reduction control signal NRCON. The noise reduction control signal NRCON may be provided to the transmitter 30, and the transmitter 30 may perform a noise reduction operation based on the noise reduction control signal NRCON. For example, in the operation mode in which the transmitter 30 and the receiver 40 are enabled together, while the transmitter 30 generates and outputs the first signal based on the first data TDAT, noise generated by the transmitter 30 may be prevented from being transmitted to the receiver 40 through the I/O port PT, based on the noise reduction control signal NRCON.

For example, the noise reduction circuit 20 may receive an enable signal EN, and may generate the noise reduction control signal NRCON based on the enable signal EN. The enable signal EN may be provided in synchronization with the first data TDAT. For example, the enable signal EN may be activated during an activation time interval for the first data TDAT (e.g., a time interval during which the first data TDAT is transmitted), and may be deactivated during a deactivation time interval for the first data TDAT (e.g., a time interval during which the first data TDAT is not transmitted). For example, since the enable signal EN is synchronized with the first data TDAT, the enable signal EN may be provided from the processor, similarly to the first data TDAT.

Detailed configurations and operations of the noise reduction circuit 20 will be described later.

In a transceiver structure where an I/O port is shared by a transmitter and a receiver, there can be a problem in which a signal output from the transmitter is reflected and transmitted to the receiver. To prevent or reduce the effects of such problem, schemes for reducing noise of the transmitter itself, schemes using additional external components such as circulators, and/or schemes using additional technologies such as self-interference cancellation (SIC) have been studied. However, when reducing the noise of the transmitter itself, current consumption of the transmitter is typically greatly increased and it is difficult to reach target output power. In addition, when using the additional external components and/or the additional technologies, it is typically difficult to ensure wide bandwidth frequencies.

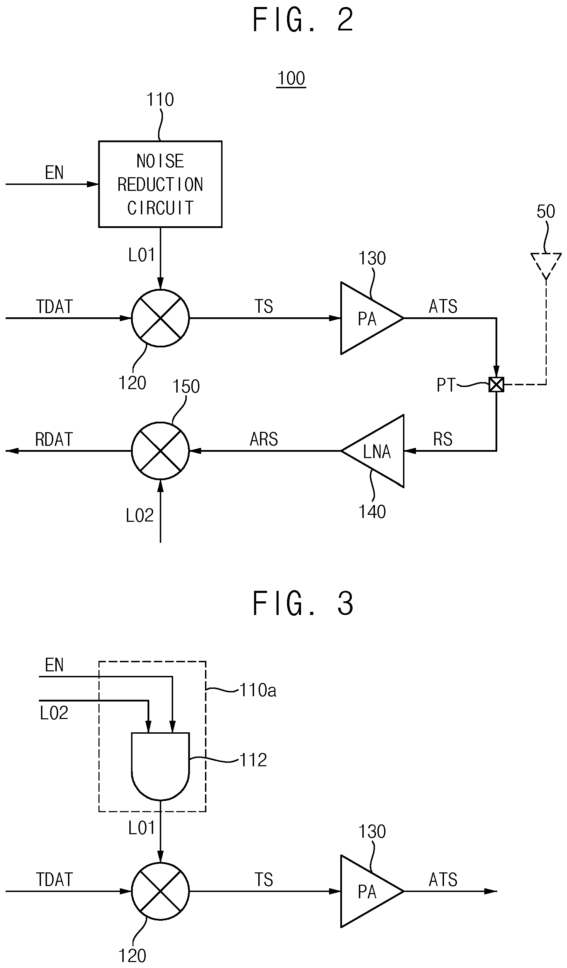

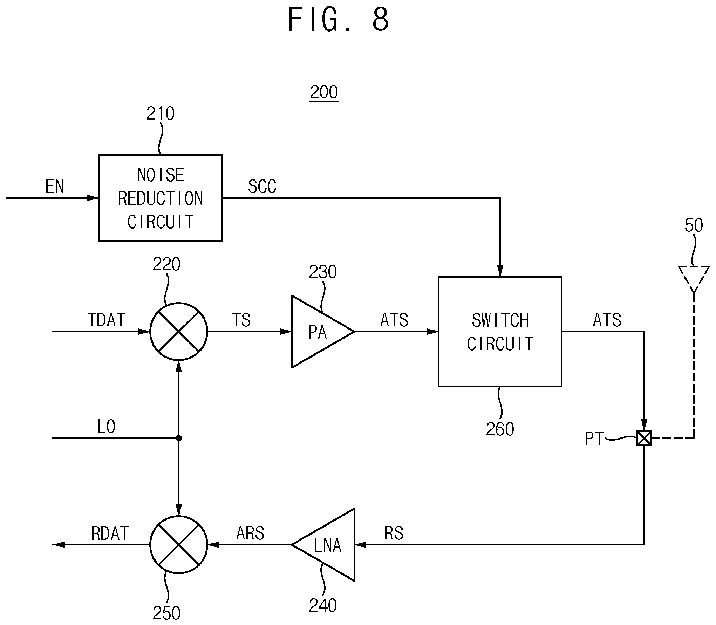

In the transceiver 10 according to example embodiments, the I/O port PT may be shared by the transmitter 30 and the receiver 40, and the noise reduction circuit 20 that generates the noise reduction control signal NRCON in synchronization with the first data TDAT may be included. For example, the noise reduction control signal NRCON may be generated based on the enable signal EN. For example, the noise reduction control signal NRCON and the enable signal EN may be activated (e.g., in an active or activated state) during the activation time interval for the first data TDAT, and may be deactivated (e.g., in an inactive or deactivated state) during the deactivation time interval for the first data TDAT. For example, as will be described with reference to FIG. 2, a mixer included in the transmitter 30 may be selectively turned on and off based on the enable signal EN. For example, as will be described with reference to FIG. 8, a switch circuit included in the transmitter 30 may be selectively turned on and off based on the enable signal EN. Accordingly, the noise by the transmitter 30 may be efficiently prevented from being transmitted to the receiver 40, and the transceiver 10 may have relatively improved or enhanced performance.

FIG. 2 is a block diagram illustrating an example of a transceiver of FIG. 1.

Referring to FIG. 2, a transceiver 100 includes a noise reduction circuit 110, a first mixer 120, a first amplifier 130, a second amplifier 140, and an I/O port PT. The transceiver 100 may further include a second mixer 150.

The noise reduction circuit 110 and the I/O port PT may correspond to the noise reduction circuit 20 and the I/O port PT of FIG. 1, respectively. The first mixer 120 and the first amplifier 130 may be included in the transmitter 30 of FIG. 1. The second amplifier 140 and the second mixer 150 may be included in the receiver 40 of FIG. 1. The descriptions repeated with or overlapping with descriptions of FIG. 1 will be omitted in the interest of brevity.

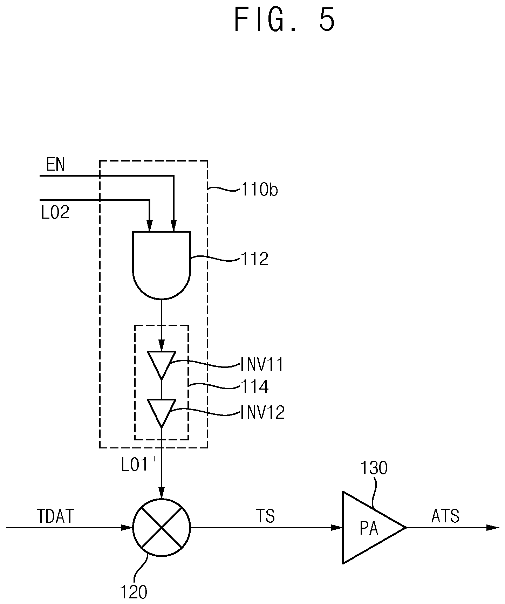

The noise reduction circuit 110 generates a first clock signal LO1 that is provided to the first mixer 120. For example, the noise reduction circuit 110 may activate the first clock signal LO1 during an activation time interval for the first data TDAT, and may deactivate the first clock signal LO1 during a deactivation time interval for the first data TDAT. For example, the first clock signal LO1 may be included in the noise reduction control signal NRCON of FIG. 1. For example, the noise reduction circuit 110 may receive an enable signal EN that is activated (e.g., in an active or activated state) during the activation time interval for the first data TDAT and is deactivated (e.g., in an inactive or deactivated state) during the deactivation time interval for the first data TDAT, and may generate the first clock signal LO1 based on the enable signal EN. Examples of the noise reduction circuit 110 will be described with reference to FIGS. 3 and 5.

The first mixer 120 receives the first data TDAT, and generates a first signal TS that is to be transmitted to an external device based on the first data TDAT and the first clock signal LO1. For example, the first mixer 120 may be a mixer for up-conversion. For example, the first mixer 120 may be a passive mixer.

The first amplifier 130 amplifies the first signal TS, and generates an amplified first signal ATS. For example, the first amplifier 130 may be a power amplifier (PA).

The second amplifier 140 amplifies a second signal RS received from the external device, and generates an amplified second signal ARS. For example, the second amplifier 140 may be a low noise amplifier (LNA).

The second mixer 150 may generate second data RDAT based on the amplified second signal ARS and a second clock signal LO2. For example, the second mixer 150 can be a mixer for down-conversion.

The I/O port PT is shared by the first amplifier 130 and the second amplifier 140, and outputs the amplified first signal ATS or receives the second signal RS through an antenna 50.

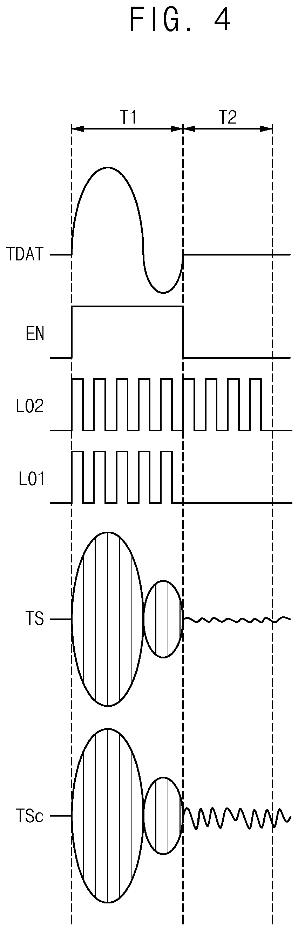

In some example embodiments, the first clock signal LO1, which is generated based on the enable signal EN, may be toggled during the activation time interval for the first data TDAT, and may be deactivated during the deactivation time interval for the first data TDAT. Therefore, the first mixer 120, which operates based on the first clock signal LO1, may be turned on and may normally operate during the activation time interval for the first data TDAT, and may be turned off and may not operate during the deactivation time interval for the first data TDAT. Examples of the first data TDAT, the enable signal EN and the first clock signal LO1 will be described with reference to FIG. 4.

FIG. 3 is a block diagram illustrating an example of a noise reduction circuit included in a transceiver of FIG. 2.

Referring to FIG. 3, a noise reduction circuit 110a may include an AND gate 112. For convenience of illustration, the first mixer 120 and the first amplifier 130 on the transmitter side, which operate in conjunction with the noise reduction circuit 110a, are illustrated together.

The AND gate 112 may generate the first clock signal LO1 by performing an AND operation on the enable signal EN and the second clock signal LO2.

In some example embodiments, the second clock signal LO2 may always be toggled regardless of the enable signal EN. The AND operation may be performed on the enable signal EN and the second clock signal LO2, and thus the first clock signal LO1 that is toggled during the activation time interval for the first data TDAT and is deactivated during the deactivation time interval for the first data TDAT may be generated.

However, example embodiments are not limited thereto, and the noise reduction circuit 110a may be implemented in at least one of various structures for generating the first clock signal LO1, which is toggled during the activation time interval for the first data TDAT and is deactivated during the deactivation time interval for the first data TDAT, based on the enable signal EN.

FIG. 4 is a diagram for describing an operation by a noise reduction circuit of FIG. 3.

Referring to FIGS. 3 and 4, examples of the first data TDAT, the enable signal EN, the first and second clock signals LO1 and LO2, and the first signal TS according to example embodiments are illustrated, and an example of a first signal TSc by a conventional scheme is also illustrated.

The first data TDAT may include an activation time interval T1 and a deactivation time interval T2. For example, the activation time interval T1 may be a time interval in which a voltage level of the first data TDAT is changed, e.g., a time interval in which the first data TDAT has specific values. For example, the activation time interval T1 may be a time interval in which the data signal includes data (e.g. data to be transmitted). For example, the deactivation time interval T2 may be a time interval in which the voltage level of the first data TDAT is not changed and is maintained, e.g., a time interval in which the first data TDAT does not have specific values (or a time interval in which no data value exists). For example, the deactivation time interval T2 may be a time interval in which the data signal does not include data (e.g. does not include data to be transmitted).

The enable signal EN may be activated during the activation time interval T1 of the first data TDAT, and may be deactivated during the deactivation time interval T2 of the first data TDAT. For example, the activation of the enable signal EN may represent or indicate that the enable signal EN has a logic high level, and the deactivation of the enable signal EN may represent or indicate that the enable signal EN has a logic low level. However, example embodiments are not limited thereto.

The second clock signal LO2 may always be toggled during both the activation time interval T1 and the deactivation time interval T2 of the first data TDAT. For example, the toggling of the second clock signal LO2 may represent or indicate that the second clock signal LO2 alternately has a logic high level and a logic low level, e.g., a voltage level of the second clock signal LO2 is regularly changed (or swung) between a logic high level and a logic low level.

The first clock signal LO1 may be toggled during the activation time interval T1 of the first data TDAT, and may be deactivated during the deactivation time interval T2 of the first data TDAT. For example, the toggling of the first clock signal LO1 may represent or indicate that the first clock signal LO1 alternately has a logic high level and a logic low level, and the deactivation of the first clock signal LO1 may represent or indicate that the first clock signal LO1 has a logic low level.

The first signal TS, which is generated based on the first data TDAT and the first clock signal LO1 according to example embodiments, may have an up-converted waveform in which the first data TDAT and the first clock signal LO1 are mixed during the activation time interval T1 of the first data TDAT, and may have relatively small or low noise because the first clock signal LO1 is deactivated and the first mixer 120 is turned off during the deactivation time interval T2 of the first data TDAT.

In contrast, the first signal TSc, which is generated based on the first data TDAT and the second clock signal LO2 by the conventional scheme, may have relatively large or high noise because the first clock signal LO1 is toggled and the first mixer 120 is turned on even during the deactivation time interval T2 of the first data TDAT.

In terms of signal-to-noise ratio (SNR), noise from an input may be the most dominant. Therefore, the first mixer 120 may be tuned off using the first clock signal LO1 according to example embodiments when there is no data or signal (e.g., during the deactivation time interval T2 of the first data TDAT), and thus noise transmitted to the receiver may be shielded and the current consumption may be reduced. For example, as illustrated in FIG. 3, the first mixer 120 may be selectively turned on and off by receiving the enable signal EN and using the AND gate 112, and such configuration may be referred to as a switching AND gate type mixer.

FIG. 5 is a block diagram illustrating an example of a noise reduction circuit included in a transceiver of FIG. 2. The descriptions repeated with or overlapping with descriptions of FIG. 3 will be omitted in the interest of brevity.

Referring to FIG. 5, a noise reduction circuit 110b may include an AND gate 112 and a buffer circuit 114.

The buffer circuit 114 may be disposed or located between the AND gate 112 and the first mixer 120, and may generate a first clock signal LO1' based on an output of the AND gate 112. The first clock signal LO1' may be substantially the same as the first clock signal LO1 in FIG. 3.

For example, the buffer circuit 114 may include a plurality of inverters INV11 and INV12 that are connected in series. For convenience of illustration, only two inverters INV11 and INV12 are illustrated, but example embodiments are not limited thereto. The inverters INV11 and INV12 may serve as a buffer for driving a clock signal with a high radio frequency (RF) frequency.

However, example embodiments are not limited thereto, and the noise reduction circuit 110 may further include at least one of other components used for or necessary for the operation of the transceiver in addition to the AND gate 112.

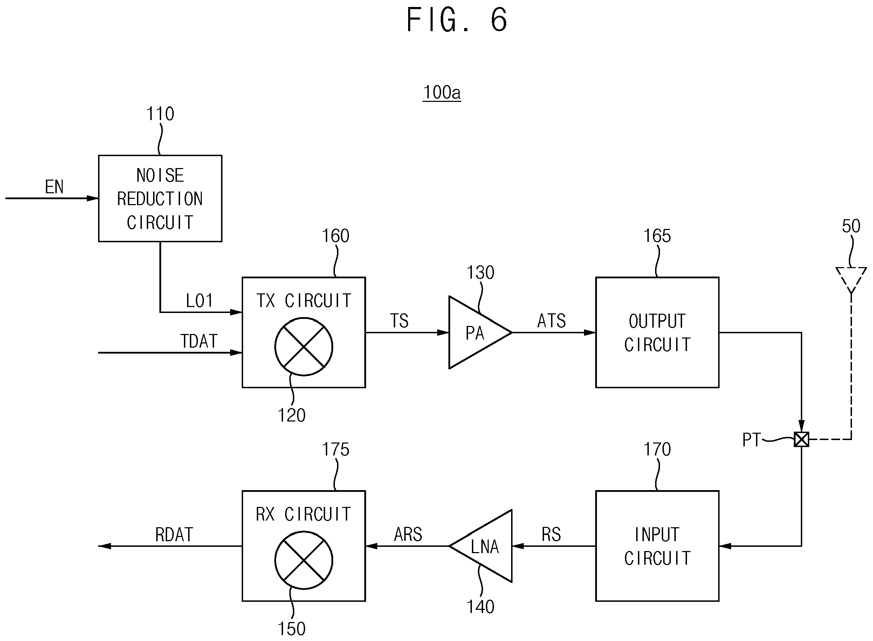

FIG. 6 is a block diagram illustrating an example of a transceiver of FIG. 1. The descriptions repeated with or overlapping with descriptions of FIG. 2 will be omitted in the interest of brevity.

Referring to FIG. 6, a transceiver 100a includes a noise reduction circuit 110, a first mixer 120, a first amplifier 130, a second amplifier 140, and an I/O port PT. The transceiver 100a may further include a second mixer 150, a transmission (TX) circuit 160, an output circuit 165, an input circuit 170 and a reception (RX) circuit 175.

The transmission circuit 160 may be disposed at the front end of the first amplifier 130, and may generate the first signal TS based on the first data TDAT. For example, the first mixer 120 may be included in the transmission circuit 160. For example, although not illustrated in detail, the transmission circuit 160 may further include an analog filter, etc.

The output circuit 165 may be disposed at the rear end of the first amplifier 130, and may output the amplified first signal ATS. For example, although not illustrated in detail, the output circuit 165 may include an impedance matching circuit, a filter, etc.

The input circuit 170 may be disposed at the front end of the second amplifier 140, and may receive the second signal RS. For example, although not illustrated in detail, the input circuit 170 may include an impedance matching circuit, a filter, etc.

The reception circuit 175 may be disposed at the rear end of the second amplifier 140, and may generate second data RDAT based on the amplified second signal ARS. For example, the second mixer 150 may be included in the reception circuit 175. For example, although not illustrated in detail, the reception circuit 175 may further include an analog filter, etc.

In some example embodiments, the transmitter and the receiver (or the transmission path and the reception path) may be implemented to generate differential signals. In some example embodiments, the transmission circuit 160 and the output circuit 165 may include at least one current source, at least one resistor, at least one capacitor, at least one transformer, a pre-power amplifier (PPA), etc.

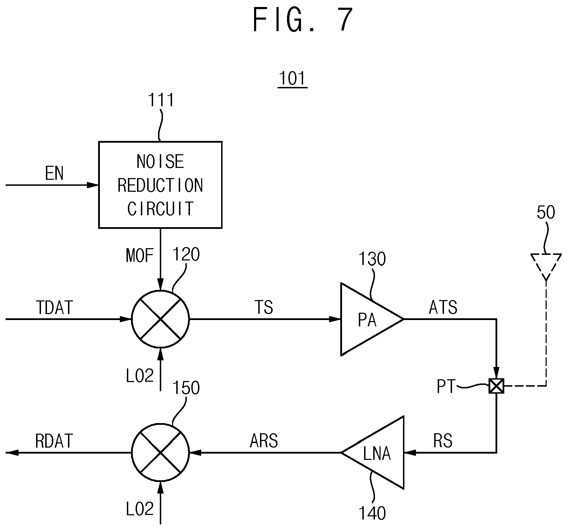

FIG. 7 is a block diagram illustrating an example of a transceiver of FIG. 1. The descriptions repeated with or overlapping with descriptions of FIG. 2 will be omitted in the interest of brevity.

Referring to FIG. 7, a transceiver 101 includes a noise reduction circuit 111, a first mixer 120, a first amplifier 130, a second amplifier 140 and an I/O port PT. The transceiver 101 may further include a second mixer 150.

Unlike the example of FIG. 2 in which the noise reduction circuit 110 generates the first clock signal LO1 as the noise reduction control signal NRCON and the first mixer 120 is turned on and off based on the first clock signal LO1, the noise reduction circuit 111 in FIG. 7 may generate a mixer on/off signal MOF as the noise reduction control signal NRCON, and the first mixer 120 in FIG. 7 may be turned on and off based on the mixer on/off signal MOF and may operate based on the second clock signal LO2. For example, the mixer on/off signal MOF may be activated during the activation time interval for the first data TDAT, and may be deactivated during the deactivation time interval for the first data TDAT. For example, the noise reduction circuit 111 may generate the mixer on/off signal MOF based on the enable signal EN, and a waveform of the mixer on/off signal MOF may be similar to that of the enable signal EN. For example, the first mixer 120 may be turned on during an activation time interval (e.g., a time interval having a logic high level) of the mixer on/off signal MOF, and may be turned off during a deactivation time interval (e.g., a time interval having a logic low level) of the mixer on/off signal MOF.

FIG. 8 is a block diagram illustrating an example of a transceiver of FIG. 1.

Referring to FIG. 8, a transceiver 200 includes a noise reduction circuit 210, a first mixer 220, a first amplifier 230, a second amplifier 240, an I/O port PT and a switch circuit 260. The transceiver 200 may further include a second mixer 250.

The noise reduction circuit 210 and the I/O port PT may correspond to the noise reduction circuit 20 and the I/O port PT of FIG. 1, respectively. The first mixer 220, the first amplifier 230 and the switch circuit 260 may be included in the transmitter 30 of FIG. 1. The second amplifier 240 and the second mixer 250 may be included in the receiver 40 of FIG. 1. The descriptions repeated with or overlapping with descriptions of FIG. 1 will be omitted in the interest of brevity.

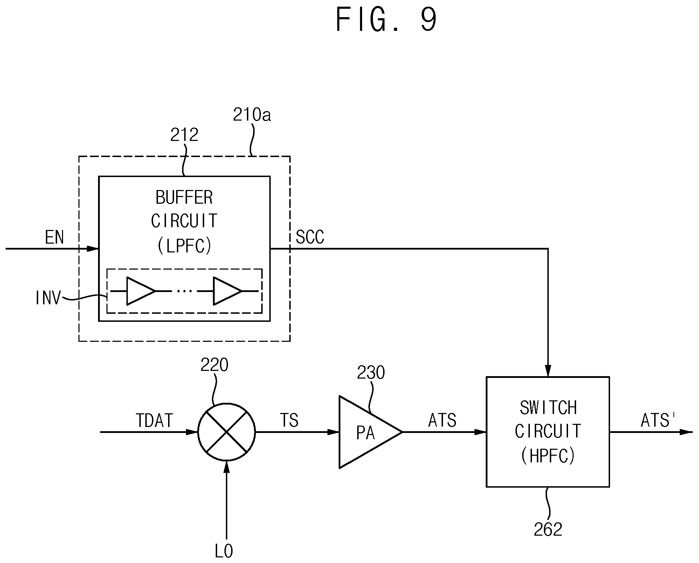

The noise reduction circuit 210 generates a switch control signal SCC that is provided to the switch circuit 260. For example, the noise reduction circuit 210 may activate the switch control signal SCC during an activation time interval for the first data TDAT, and may deactivate the switch control signal SCC during a deactivation time interval for the first data TDAT. For example, the switch control signal SCC may be included in the noise reduction control signal NRCON of FIG. 1. For example, the noise reduction circuit 210 may receive an enable signal EN that is activated during the activation time interval for the first data TDAT and is deactivated during the deactivation time interval for the first data TDAT, and may generate the switch control signal SCC based on the enable signal EN. Examples of the noise reduction circuit 210 will be described with reference to FIGS. 9, 11 and 15.

The first mixer 220 receives the first data TDAT, and generates a first signal TS that is to be transmitted to an external device based on the first data TDAT and a clock signal LO. For example, the first mixer 220 may be similar to the first mixer 120 of FIG. 2. For example, the clock signal LO may be similar to the first clock signal LO1 of FIG. 2 or second clock signal LO2 of FIG. 7.

The first amplifier 230 amplifies the first signal TS, and generates an amplified first signal ATS. For example, the first amplifier 230 may be similar to the first amplifier 130 of FIG. 2.

The second amplifier 240 amplifies a second signal RS received from the external device, and generates an amplified second signal ARS. For example, the second amplifier 240 may be similar to the second amplifier 140 of FIG. 2.

The second mixer 250 may generate second data RDAT based on the amplified second signal ARS and the clock signal LO. For example, the second mixer 250 may be similar to the second mixer 150 of FIG. 2.

The I/O port PT is shared by the first amplifier 130 and the second amplifier 140, and outputs the amplified first signal ATS or receives the second signal RS through an antenna 50.

The switch circuit 260 is disposed or located between the first amplifier 230 and the I/O port PT, is turned on and off based on the switch control signal SCC, and outputs a signal ATS' corresponding to the amplified first signal ATS. For example, the switch circuit 260 may be turned on in the transmission mode for transmitting the amplified first signal ATS to the external device, and may be turned off in the reception mode for receiving the second signal RS from the external device.

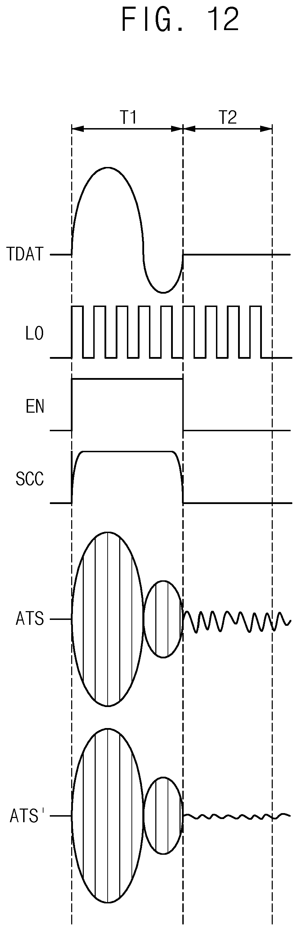

In some example embodiments, the switch control signal SCC, which is generated based on the enable signal EN, may be activated during the activation time interval for the first data TDAT, and may be deactivated during the deactivation time interval for the first data TDAT. Therefore, the switch circuit 260, which operates based on the switch control signal SCC, may be turned on (or closed) and may electrically connect the first amplifier 230 with the I/O port PT during the activation time interval for the first data TDAT, and may be turned off (or opened) and may block an electrical connection between the first amplifier 230 and the I/O port PT during the deactivation time interval for the first data TDAT. Therefore, the switch circuit 260 may not be continually turned on in the transmission mode, and may instead be selectively turned on and off in the transmission mode. Examples of the first data TDAT, the enable signal EN and the switch control signal SCC will be described with reference to FIG. 12.

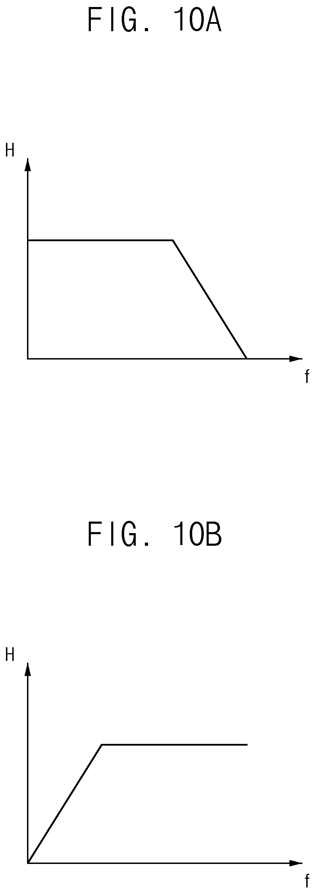

FIG. 9 is a block diagram illustrating an example of a noise reduction circuit included in a transceiver of FIG. 8. FIGS. 10A and 10B are diagrams for describing a noise reduction circuit of FIG. 9.

Referring to FIGS. 9, 10A and 10B, a noise reduction circuit 210a may include a buffer circuit 212. For convenience of illustration, the first mixer 220, the first amplifier 230 and the switch circuit 262 on the transmitter side, which operate in conjunction with the noise reduction circuit 210a, are illustrated together.

The buffer circuit 212 may generate the switch control signal SCC based on the enable signal EN, and may be implemented to have the characteristics LPFC of a low pass filter. For example, the buffer circuit 212 may include a plurality of inverters INV that are connected in series. For example, the relationship between the frequency f and the transfer function H of the buffer circuit 212 may be implemented as illustrated in FIG. 10A.

The switch circuit 262 may be implemented to have the characteristics HPFC of a high pass filter. For example, the relationship between the frequency f and the transfer function H of the switch circuit 262 may be implemented as illustrated in FIG. 10B.

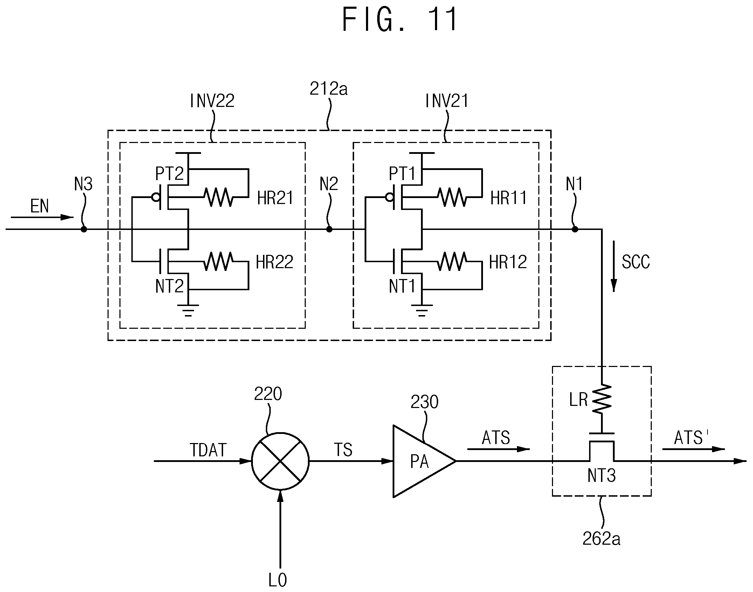

FIG. 11 is a diagram illustrating an example of a buffer circuit and a switch circuit of FIG. 9.

Referring to FIG. 11, a buffer circuit 212a may include a plurality of inverters INV21 and INV22. For convenience of illustration, only two inverters INV21 and INV22 that are disposed close to the switch circuit 262a are illustrated, but example embodiments are not limited thereto.

The inverter INV21 that is disposed closest to the switch circuit 262a may include transistors PT1 and NT1 and resistors HR11 and HR12.

The transistor PT1 may be connected between a power supply voltage and a first node N1 outputting the switch control signal SCC. The transistor NT1 may be connected between the first node N1 and a ground voltage. Gates (or gate electrodes) of the transistors PT1 and NT1 may be connected to a second node N2. For example, the transistor PT1 may be a p-type metal oxide semiconductor (PMOS) transistor, and the transistor NT1 may be an n-type metal oxide semiconductor (NMOS) transistor.

The resistor HR11 may be connected between a body of the transistor PT1 and the power supply voltage. The resistor HR12 may be connected between a body of the transistor NT1 and the ground voltage. A body separation structure in which the body of the transistor PT1 is separated from the power supply voltage may be implemented by the resistor HR11, and a body separation structure in which the body of the transistor NT1 is separated from the ground voltage may be implemented by the resistor HR12. Each of the resistors HR11 and HR12 may be referred to as a choke resistor.

As described above, when the inverters INV21 and INV22 are implemented with the body separation structure, the buffer circuit 212a may have the characteristics LPFC of the low pass filter.

The inverter INV22 that is adjacent to the inverter INV21 may have a structure substantially the same as that of the inverter INV21. For example, the inverter INV22 may include transistors PT2 and NT2 and resistors HR21 and HR22. The transistor PT2 may be connected between the power supply voltage and the second node N2. The transistor NT2 may be connected between the second node N2 and the ground voltage. Gates of the transistors PT2 and NT2 may be connected to a third node N3 receiving the enable signal EN. The resistor HR21 may be connected between a body of the transistor PT2 and the power supply voltage. The resistor HR22 may be connected between a body of the transistor NT2 and the ground voltage.

The switch circuit 262a may include a transistor NT3 and a resistor (LR). The transistor NT3 may be connected between the output of the first amplifier 230 and the I/O port PT. The resistor LR may be connected between the first node N1 and a gate of the transistor NT3. The resistor LR may also be referred to as a choke resistor.

In some example embodiments, each of the resistors HR11 and HR12 may have a relatively large resistance, and the resistor LR may have a relatively small resistance. For example, a resistance of the resistor HR11 and a resistance of the resistor HR12 may be greater than a reference resistance, and a resistance of the resistor LR may be less than the reference resistance. For example, the resistors HR11 and HR12 may be implemented as high-Z (e.g. high-impedance) choke resistors, and the resistor LR may be implemented as a low-Z (e.g. low-impedance) choke resistor. A high-Z choke resistor may be a choke resistor that has a higher impedance than a low-Z choke resistor.

As described above, when the inverters INV21 and INV22 are implemented with the body separation structure, and when the resistor LR connected to the gate of the transistor NT3 is implemented as the low-Z choke resistor, the switch circuit 262a may have the characteristics HPFC of the high pass filter.

Conventionally, to minimize the loss of a transistor included in a switch circuit, gain boosting was designed by connecting high-Z choke resistors having relatively large resistances to a gate, a source and a body of the transistor. However, there was a problem that it is difficult to turn the transistor on and off because there was no frequency response when turning the transistor on and off.

In the transceiver according to example embodiments, to facilitate turning on and off of the transistor NT3, the resistor LR that is implemented as the low-Z choke resistor may be used such that a resistance of the choke resistor connected to the gate of the transistor NT3 is reduced. However, when the low-Z choke resistor LR is used, there may be a problem in that performance of the transistor NT3 is degraded or deteriorated. To address this problem, the resistors HR11 and HR12 that are implemented as the high-Z choke resistors may be used, and may be connected to the bodies of the transistors PT1 and NT1 included in the inverter INV21 that generates the switch control signal SCC for the gate control of the transistor NT3. Therefore, from the gate of the transistor NT3, the high-Z choke may be visible toward the AC ground, and at the same time, the on/off operation for the gate of the transistor NT3 may be normally performed using the switch control signal SCC.

However, example embodiments are not limited thereto. For example, the buffer circuit 212a may be implemented with at least one of various structures to have the characteristics LPFC of the low pass filter, and the switch circuit 262a may be implemented with at least one of various structures to have the characteristics HPFC of the high pass filter.

FIGS. 12, 13 and 14 are diagrams for describing an operation by a noise reduction circuit of FIG. 9.

Referring to FIGS. 9 and 12, examples of the first data TDAT, the clock signal LO, the enable signal EN, the switch control signal SCC, the amplified first signal ATS, and the signal ATS' corresponding to the amplified first signal ATS according to example embodiments are illustrated. The descriptions repeated with or overlapping with descriptions of FIG. 4 will be omitted in the interest of brevity.

The first data TDAT may include an activation time interval T1 and a deactivation time interval T2.

The clock signal LO may always be toggled during both the activation time interval T1 and the deactivation time interval T2 of the first data TDAT.

The enable signal EN may be activated during the activation time interval T1 of the first data TDAT, and may be deactivated during the deactivation time interval T2 of the first data TDAT.

The switch control signal SCC may have a low-pass filtered waveform of the enable signal EN.

The amplified first signal ATS, which is output from the first amplifier 230, may have an up-converted waveform in which the first data TDAT and the clock signal LO are mixed during the activation time interval T1 of the first data TDAT, and may have relatively large or high noise because the clock signal LO is continuously toggled and various noises occur inside the transmitter during the deactivation time interval T2 of the first data TDAT.

In contrast, the signal ATS' corresponding to the amplified first signal ATS, which is generated using the buffer circuit 212 having the characteristics LPFC of the low pass filter and the switch circuit 262 having the characteristics HPFC of the high pass filter, may have relatively small or low noise during the deactivation time interval T2 of the first data TDAT.

In the transceiver according to example embodiments, the signal ATS' may be output through the switch circuit 262 having the characteristics HPFC of the high pass filter, and the buffer circuit 212 for driving the on/off of the switch circuit 262 may have the characteristics LPFC of the low pass filter in the direction from viewed the switch circuit 262. In addition, to easily turn the switch circuit 262 on and off, the resistance of the choke resistor LR connected to the gate of the transistor NT3 included in the switch circuit 262 should be reduced, and additionally, the path viewed from the low pass filter should have the AC response. Therefore, the noise and leakage transmitted to the receiver side may be reduced when there is no data or signal (e.g., during the deactivation time interval T2 of the first data TDAT). For example, as illustrated in FIG. 11, the transistor NT3 may be implemented using the low-Z choke resistor LR, and the inverters INV21 and INV22 may be implemented with the body separation structure using the high-Z choke resistors HR11 and HR12, and such configuration may be referred to as a low-Z choke switching RF switch with body boosting inverter.

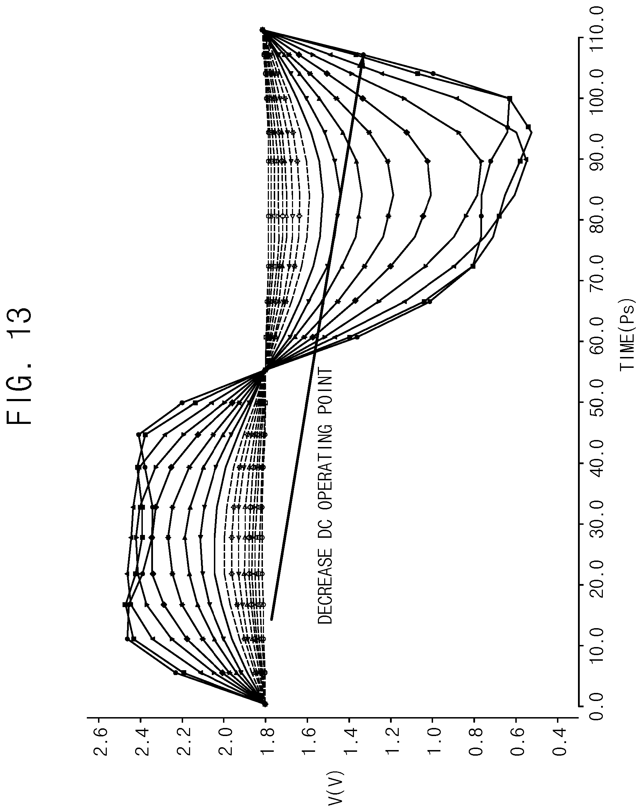

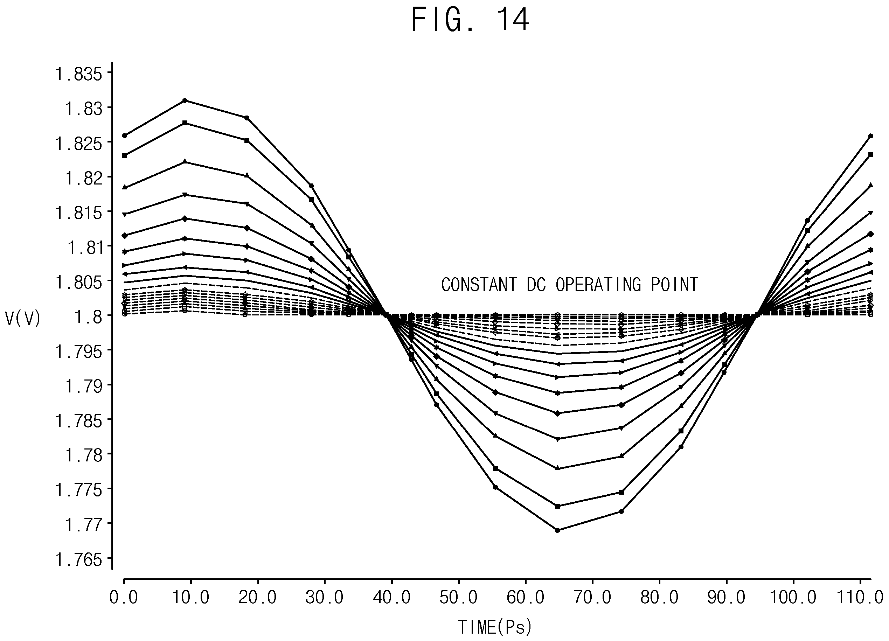

Referring to FIGS. 13 and 14, the importance of the body separation structure of the inverters INV21 and INV22 is illustrated.

As illustrated in FIG. 13, when the high-Z choke resistors HR11 and HR12 are not included, e.g., when the inverters are not implemented with the body separation structure, threshold voltages of the transistors included in the inverter may be significantly changed, and diodes of the transistors included in the inverter may be turned on as the output swing increases. Thus, there may be problems in that direct current (DC) operating point of the inverters are reduced and the characteristics of the switching circuit are degraded or deteriorated.

As illustrated in FIG. 14, when the high-Z choke resistors HR11 and HR12 are included according to example embodiments, e.g., when the inverters INV21 and INV22 are implemented with the body separation structure according to example embodiments, diodes of the transistors included in the inverter INV21 and INV22 may not be turned on even if the output swing increases. Accordingly, the DC operating point of the inverters INV21 and INV22 may be maintained constant.

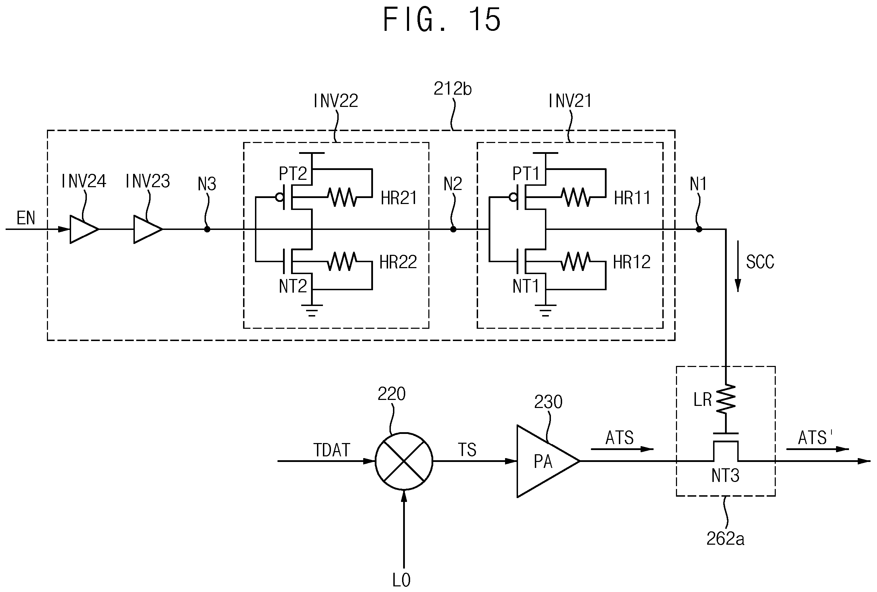

FIG. 15 is a diagram illustrating an example of a buffer circuit and a switch circuit of FIG. 9. The descriptions repeated with or overlapping with descriptions of FIG. 11 will be omitted in the interest of brevity.

Referring to FIG. 15, a buffer circuit 212b may include a plurality of inverters INV21, INV22, INV23 and INV24.

The inverters INV21 and INV22 that are disposed close (e.g. adjacent) to the switch circuit 262a may be implemented with the body separation structure described with reference to FIG. 11. However, the inverters INV23 and INV24 that are disposed far (e.g. further) away from the switch circuit 262a may not be implemented with the body separation structure. For example, although not illustrated in detail, each of the inverters INV23 and INV24 may include two transistors (e.g., PMOS and NMOS transistors) connected between the power supply voltage and the ground voltage, and a body of each of the two transistors may be connected to the power supply voltage or the ground voltage without an additional resistor.

However, example embodiments are not limited thereto, and the noise reduction circuit 210 may further include at least one of other components necessary for the operation of the transceiver in addition to the buffer circuit 212.

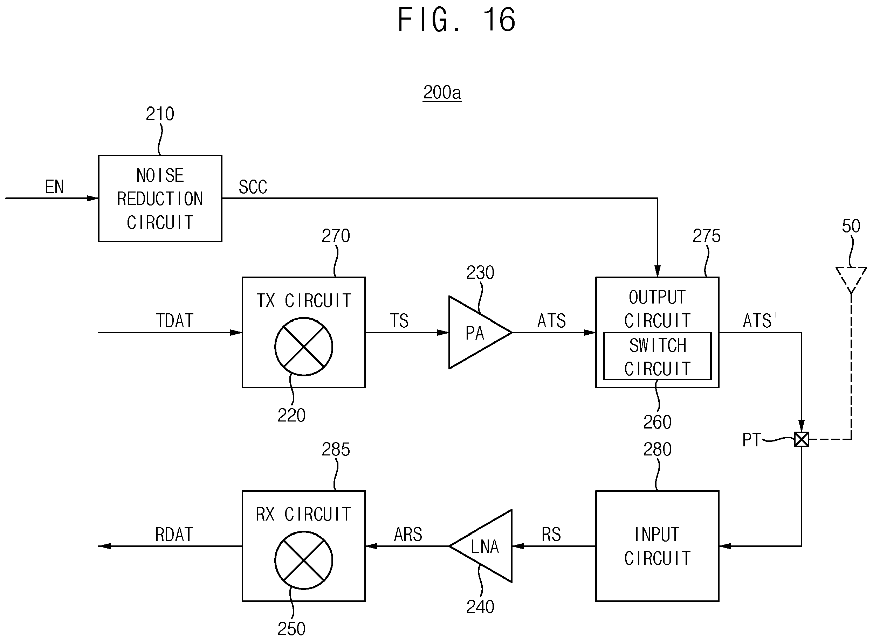

FIG. 16 is a block diagram illustrating an example of a transceiver of FIG. 1. The descriptions repeated with or overlapping with descriptions of FIGS. 6 and 8 will be omitted in the interest of brevity.

Referring to FIG. 16, a transceiver 200a includes a noise reduction circuit 210, a first mixer 220, a first amplifier 230, a second amplifier 240, an I/O port PT and a switch circuit 260. The transceiver 200a may further include a second mixer 250, a transmission circuit 270, an output circuit 275, an input circuit 280 and a reception circuit 285.

The transmission circuit 270 may be disposed at the front end of the first amplifier 230, and may be substantially the same as the transmission circuit 160 of FIG. 6.

The output circuit 275 may be disposed at the rear end of the first amplifier 230, and may be substantially the same as the output circuit 165 of FIG. 6, except that the output circuit 275 may be combined with the switch circuit 260.

The input circuit 280 may be disposed at the front end of the second amplifier 240, and may be substantially the same as the input circuit 170 of FIG. 6.

The reception circuit 285 may be disposed at the rear end of the second amplifier 240, and may be substantially the same as the reception circuit 175 of FIG. 6.

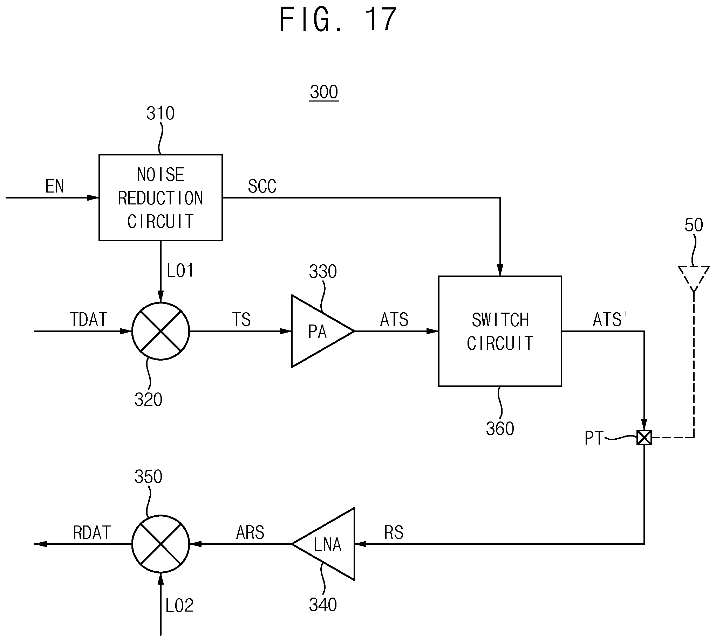

FIG. 17 is a block diagram illustrating an example of a transceiver of FIG. 1.

Referring to FIG. 17, a transceiver 300 includes a noise reduction circuit 310, a first mixer 320, a first amplifier 330, a second amplifier 340, an I/O port PT and a switch circuit 360. The transceiver 300 may further include a second mixer 350.

The noise reduction circuit 310 and the I/O port PT may correspond to the noise reduction circuit 20 and the I/O port PT of FIG. 1, respectively. The first mixer 320, the first amplifier 330 and the switch circuit 360 may be included in the transmitter 30 of FIG. 1. The second amplifier 340 and the second mixer 350 may be included in the receiver 40 of FIG. 1. The transceiver 300 may be implemented by combining the transceiver 100 of FIG. 2 and the transceiver 200 of FIG. 8. The descriptions repeated with or overlapping with descriptions of FIGS. 1, 2 and 8 will be omitted in the interest of brevity.

The noise reduction circuit 310 generates a first clock signal LO1 and a switch control signal SCC based on an enable signal EN. The first mixer 320 may be substantially the same as the first mixer 120 of FIG. 2. The first amplifier 330 may be substantially the same as the first amplifiers 130 and 230 of FIGS. 2 and 8. The second amplifier 340 may be substantially the same as the second amplifiers 140 and 240 of FIGS. 2 and 8. The second mixer 350 may be substantially the same as the second mixer 150 of FIG. 2. The switch circuit 360 may be substantially the same as the switch circuit 260 of FIG. 8.

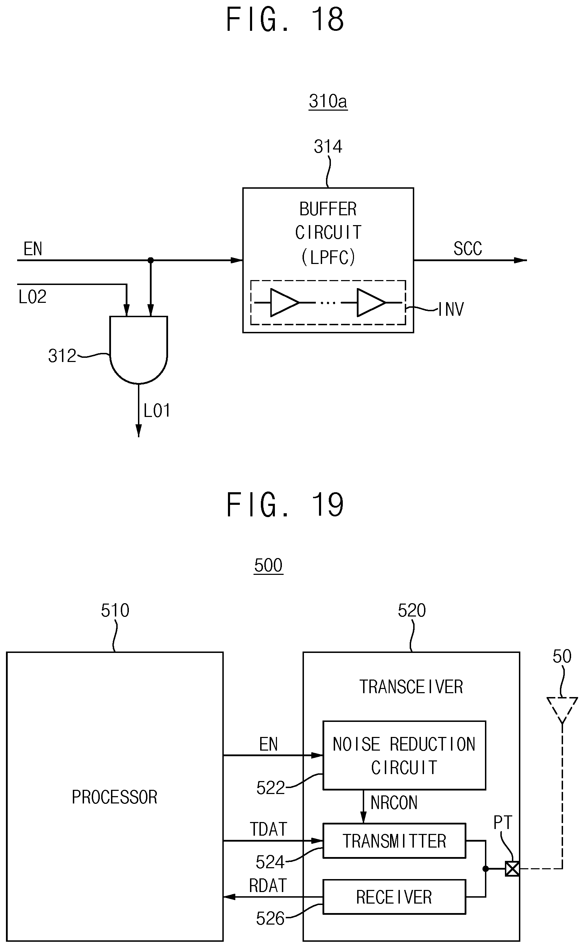

FIG. 18 is a block diagram illustrating an example of a noise reduction circuit included in a transceiver of FIG. 17.

Referring to FIG. 18, a noise reduction circuit 310a may include an AND gate 312 and a buffer circuit 314.

The AND gate 312 may be substantially the same as the AND gate 112 of FIG. 3. The buffer circuit 314 may be substantially the same as the buffer circuit 212 of FIG. 9. In some example embodiments, as described with reference to FIG. 5, the noise reduction circuit 310a may further include a buffer circuit connected to the rear end of the AND gate 112. In some example embodiments, the buffer circuit 314 may be implemented as illustrated in FIGS. 11 and 15.

FIG. 19 is a block diagram illustrating a semiconductor chip according to example embodiments.

Referring to FIG. 19, according to some embodiments, a semiconductor chip 500 includes a processor 510 and a transceiver 520.

In some example embodiments, the semiconductor chip 500 may be included in an electronic device (e.g., a communication device). In some example embodiments, the processor 510 and the transceiver 520 may be implemented as a single IC (or chip or module). For example, the processor 510 and transceiver 520 may be implemented as a system-on-chip, or as a semiconductor module including a plurality of semiconductor chips.

The processor 510 generates first data TDAT that is to be transmitted to an external device, and generates an enable signal EN that is activated during an activation time interval for the first data TDAT and is deactivated during a deactivation time interval for the first data TDAT. For example, the processor 510 may perform various signal processing such as modulation/demodulation, encoding/decoding, channel estimation, etc. The processor 510 may be referred to as a communication processor, a modem, etc. In addition, the processor 510 may transmit and receive baseband signals with the transceiver 520, and may be referred to as a baseband processor. The processor 510 may be implemented as an integrated circuit, for example, and may be a standalone semiconductor chip or package, or may be part of a semiconductor chip, semiconductor package, or semiconductor module that also includes the transceiver 520.

The transceiver 520 receives the first data TDAT and the enable signal (EN), and operates based on the first data TDAT and the enable signal EN. For example, the transceiver 520 may generate a first signal that is to be transmitted to the external device based on the first data TDAT and the enable signal EN.

The transceiver 520 may be the transceiver according to example embodiments described with reference to FIGS. 1 through 18. For example, in some embodiments, the transceiver 520 includes a noise reduction circuit 522, a transmitter 524, a receiver 526 and an I/O port PT. The transceiver 520 may have a configuration in which the I/O port PT is shared by the transmitter 524 and the receiver 526, and may include the noise reduction circuit 522 that generates a noise reduction control signal NRCON based on the enable signal EN, which is in synchronization with the first data TDAT.

For example, as described with reference to FIGS. 2 through 7, the noise reduction control signal NRCON may include the first clock signal LO1 or the mixer on/off signal MOF, and the transceiver 520 may include the switching AND gate type mixer. For example, as described with reference to FIGS. 8 through 16, the noise reduction control signal NRCON may include the switch control signal SCC, and the transceiver 520 may include the low-Z choke switching RF switch with body boosting inverter. For example, as described with reference to FIGS. 17 and 18, the noise reduction control signal NRCON may include both the first clock signal LO1 and the switch control signal SCC. The transceiver 520 may selectively turn on and off at least one of the mixer and switch circuit included in the transmitter 524 based on the enable signal EN. Accordingly, the noise by the transmitter 524 may be efficiently prevented from being transmitted to the receiver 526, and the transceiver 520 and the semiconductor chip 500 including the transceiver 520 may have relatively improved or enhanced performance.

The transceiver 520 may receive a second signal from the external device, and may generate second data RDAT based on the second signal. The processor 510 may receive the second data RDAT, and may perform data processing on the second data RDAT.

In some example embodiments, in the transmission mode, the processor 510 may provide the first data TDAT, and the transceiver 520 may receive the first data TDAT and may generate and output the first signal. In the reception mode, the transceiver 520 may receive the second signal and may generate the second data RDAT, and the processor 510 may receive the second data RDAT. When the transmitter 524 and the receiver 526 are enabled together, the transceiver 520 may prevent the noise generated by the transmitter 524 from being transmitted to the receiver 526 through the I/O port PT, based on the noise reduction control signal NRCON generated from the noise reduction circuit 522.

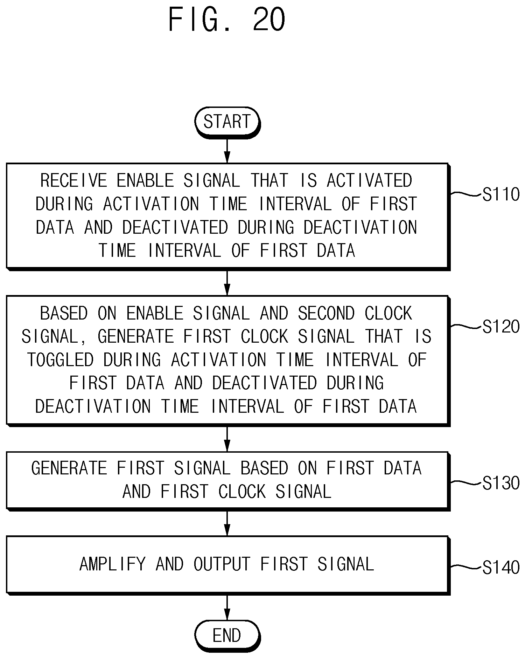

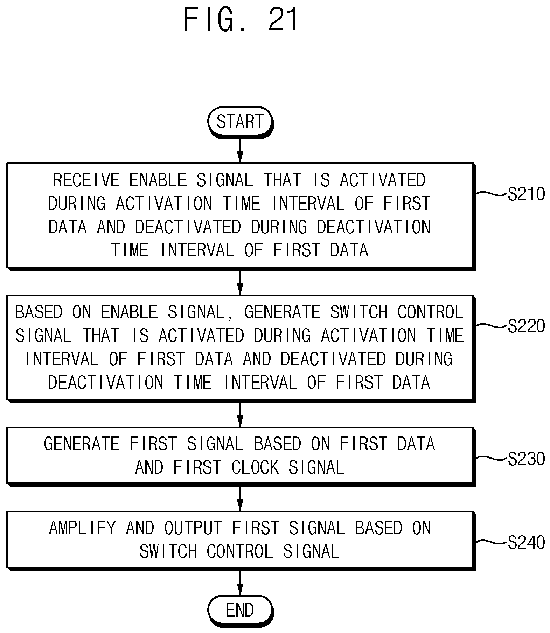

FIGS. 20 and 21 are flowcharts illustrating methods of transmitting data according to example embodiments.

Referring to FIGS. 20 and 21, methods of transmitting data according to example embodiments may be performed by the transceiver 10 according to example embodiments in which the I/O port PT is shared by the transmitter 30 and the receiver 40, and/or may be performed by the semiconductor chip 500 according to example embodiments including the transceiver according to example embodiments.

As illustrated in FIG. 20, in the method of transmitting data according to example embodiments, the enable signal EN that is activated during the activation time interval for the first data TDAT and is deactivated during the deactivation time interval for the first data TDAT is received (operation S110). Based on the enable signal EN and the second clock signal LO2, the first clock signal LO1 that is toggled during the activation time interval for the first data TDAT and is deactivated during the deactivation time interval for the first data TDAT is generated (operation S120). The first signal TS is generated based on the first data TDAT and the first clock signal LO1 (operation S130). The first signal TS is amplified, and the amplified first signal ATS is output (operation S140). For example, the method of FIG. 20 may be performed by the transceiver described with reference to FIGS. 2 through 7 and/or the semiconductor chip including the same. In some example embodiments, operation S110 may be omitted, and the mixer on/off signal MOF may be generated rather than the first clock signal LO1 in operation S120.

As illustrated in FIG. 21, in the method of transmitting data according to example embodiments, the enable signal EN that is activated during the activation time interval for the first data TDAT and is deactivated during the deactivation time interval for the first data TDAT is received (operation S210). Based on the enable signal EN, the switch control signal SCC that is activated during the activation time interval for the first data TDAT and is deactivated during the deactivation time interval for the first data TDAT is generated (operation S220). The first signal TS is generated based on the first data TDAT and the first clock signal LO (operation S230). The first signal TS is amplified, the amplified first signal ATS is generated, and the signal ATS' corresponding to the amplified first signal ATS is output based on the switch control signal SCC (operation S240). For example, the method of FIG. 21 may be performed by the transceiver described with reference to FIGS. 8 through 16 and/or the semiconductor chip including the same. In some example embodiments, operation S210 may be omitted.

In some example embodiments, a method of transmitting data according to example embodiments may be implemented by combining the method of FIG. 20 and the method of FIG. 21. In this example, the method implemented by combining the methods of FIGS. 20 and 21 may be performed by the transceiver described with reference to FIGS. 17 and 18 and/or the semiconductor chip including the same.

As will be appreciated by those skilled in the art, example embodiments may be embodied as a system, method, computer program product, and/or a computer program product embodied in one or more computer readable medium(s) having computer readable program code embodied thereon. The computer readable program code may be provided to a processor of a general purpose computer, special purpose computer, or other programmable data processing apparatus. The computer readable medium may be a computer readable signal medium or a computer readable storage medium. The computer readable storage medium may be any tangible medium that can contain or store a program for use by or in connection with an instruction execution system, apparatus, or device. For example, the computer readable medium may be a non-transitory computer readable medium.

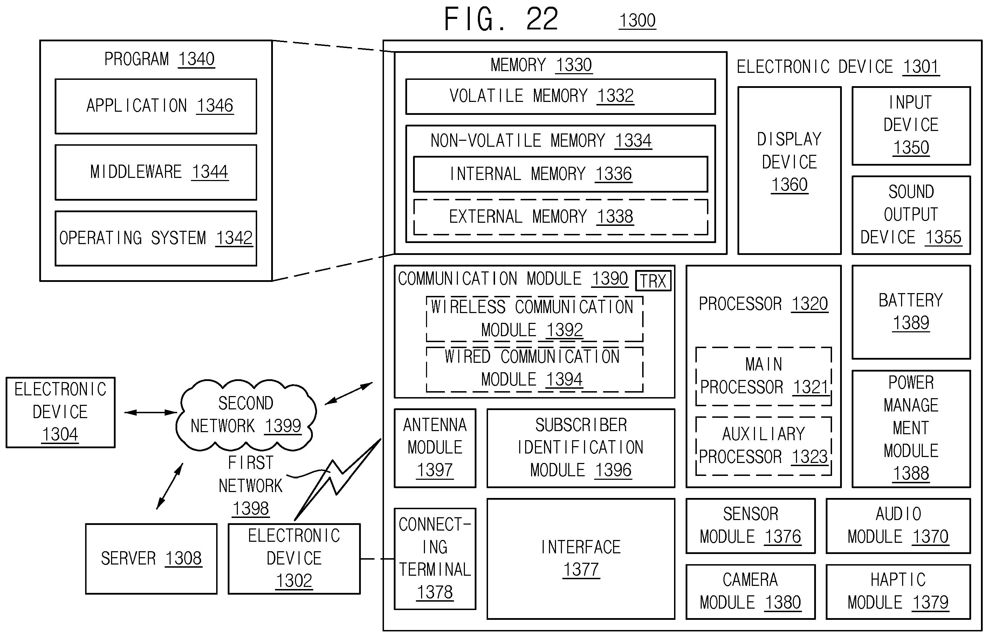

FIG. 22 is a block diagram illustrating an electronic device in a network environment according to example embodiments.

Referring to FIG. 22, an electronic device 1301 in a network environment 1300 may communicate with an electronic device 1302 via a first network 1398 (e.g., a short-range wireless communication network), or an electronic device 1304 or a server 1308 via a second network 1399 (e.g., a long-range wireless communication network). For example, the electronic device 1301 may communicate with the electronic device 1304 via the server 1308. For example, the electronic device 1301 may include a processor 1320, a memory 1330, an input device 1350, a sound output device 1355, a display device 1360, an audio module 1370, a sensor module 1376, an interface 1377, a haptic module 1379, a camera module 1380, a power management module 1388, a battery 1389, a communication module 1390, a subscriber identification module (SIM) 1396, and/or an antenna module 1397. In some example embodiments, at least one (e.g., the display device 1360 or the camera module 1380) of the components may be omitted from the electronic device 1301, or one or more other components may be added in the electronic device 1301. In some example embodiments, some of the components may be implemented as single integrated circuitry. For example, the sensor module 1376 (e.g., a fingerprint sensor, an iris sensor, or an illuminance sensor) may be implemented as embedded in the display device 1360 (e.g., a display).

The processor 1320 may execute, for example, software (e.g., a program 1340) to control at least one other component (e.g., a hardware or software component) of the electronic device 1301 coupled with the processor 1320, and may perform various data processing or computation. For example, as at least part of the data processing or computation, the processor 1320 may load a command or data received from another component (e.g., the sensor module 1376 or the communication module 1390) in a volatile memory 1332, process the command or the data stored in the volatile memory 1332, and store resulting data in a nonvolatile memory 1334. In some example embodiments, the processor 1320 may include a main processor 1321 (e.g., a central processing unit (CPU) or an application processor (AP)), and an auxiliary processor 1323 (e.g., a graphics processing unit (GPU), an image signal processor (ISP), a sensor hub processor, or a communication processor (CP)) that is operable independently from, or in conjunction with, the main processor 1321. Additionally or alternatively, the auxiliary processor 1323 may be adapted to consume less power than the main processor 1321, or to be specific to a specified function. The auxiliary processor 1323 may be implemented as separate from, or as part of the main processor 1321.

The auxiliary processor 1323 may control at least some of functions or states related to at least one component (e.g., the display device 1360, the sensor module 1376, or the communication module 1390) among the components of the electronic device 1301, instead of the main processor 1321 while the main processor 1321 is in an inactive (e.g., sleep) state, or together with the main processor 1321 while the main processor 1321 is in an active state (e.g., executing an application). In some example embodiments, the auxiliary processor 1323 (e.g., an image signal processor or a communication processor) may be implemented as part of another component (e.g., the camera module 1380 or the communication module 1390) functionally related to the auxiliary processor 1323.

The memory 1330 may store various data used by at least one component (e.g., the processor 1320 or the sensor module 1376) of the electronic device 1301. The various data may include, for example, software (e.g., the program 1340) and input data or output data for a command related thereto. The memory 1330 may include the volatile memory 1332 and/or the nonvolatile memory 1334. The memory 1330 may include an internal memory 1336 and an external memory 1338.

The program 1340 may be stored in the memory 1330 as software, and may include, for example, an operating system (OS) 1342, middleware 1344, and/or an application 1346.

The input device 1350 may receive a command or data to be used by another component (e.g., the processor 1320) of the electronic device 1301, from the outside (e.g., a user) of the electronic device 1301. The input device 1350 may include, for example, a microphone, a mouse, a keyboard, or a digital pen (e.g., a stylus pen).

The sound output device 1355 may output sound signals to the outside of the electronic device 1301. The sound output device 1355 may include, for example, a speaker or a receiver. The speaker may be used for general purposes, such as playing multimedia or playing record, and the receiver may be used for incoming calls. In some example embodiments, the receiver may be implemented as separate from, or as part of the speaker.

The display device 1360 may visually provide information to the outside (e.g., a user) of the electronic device 1301. The display device 1360 may include, for example, a display, a hologram device, or a projector and control circuitry to control a corresponding one of the display, hologram device, and projector. In some example embodiments, the display device 1360 may include touch circuitry adapted to detect a touch, or sensor circuitry (e.g., a pressure sensor) adapted to measure the intensity of force incurred by the touch.

The audio module 1370 may convert a sound into an electrical signal and vice versa. In some example embodiments, the audio module 1370 may obtain the sound via the input device 1350, or output the sound via the sound output device 1355 or a headphone of an external electronic device (e.g., an electronic device 1302) directly (e.g., wired) or wirelessly coupled with the electronic device 1301.

The sensor module 1376 may detect an operational state (e.g., power or temperature) of the electronic device 1301 or an environmental state (e.g., a state of a user) external to the electronic device 1301, and then generate an electrical signal or data value corresponding to the detected state. In some example embodiments, the sensor module 1376 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, and/or an illuminance sensor, but example embodiments are not limited thereto.

The interface 1377 may support one or more specified protocols to be used for the electronic device 1301 to be coupled with the external electronic device (e.g., the electronic device 1302) directly (e.g., wired) or wirelessly. In some example embodiments, the interface 1377 may include, for example, a high definition multimedia interface (HDMI), a universal serial bus (USB) interface, a secure digital (SD) card interface, and/or an audio interface, but example embodiments are not limited thereto.

A connecting terminal 1378 may include a connector via which the electronic device 1301 may be physically connected with the external electronic device (e.g., the electronic device 1302). In some example embodiments, the connecting terminal 1378 may include, for example, a HDMI connector, a USB connector, a SD card connector, and/or an audio connector (e.g., a headphone connector), but example embodiments are not limited thereto.

The haptic module 1379 may convert an electrical signal into a mechanical stimulus (e.g., a vibration or a movement) or electrical stimulus which may be recognized by a user via his tactile sensation or kinesthetic sensation. In some example embodiments, the haptic module 1379 may include, for example, a motor, a piezoelectric element, and/or an electric stimulator.

The camera module 1380 may capture a still image or moving images. In some example embodiments, the camera module 1380 may include one or more lenses, image sensors, image signal processors, and/or flashes.

The power management module 1388 may manage power supplied to the electronic device 1301. In some example embodiments, the power management module 1388 may be implemented as at least part of, for example, a power management integrated circuit (PMIC).

The battery 1389 may supply power to at least one component of the electronic device 1301. In some example embodiments, the battery 1389 may include, for example, a primary cell which is not rechargeable, a secondary cell which is rechargeable, or a fuel cell.

The communication module 1390 may support establishing a direct (e.g., wired) communication channel or a wireless communication channel between the electronic device 1301 and the external electronic device (e.g., the electronic device 1302, the electronic device 1304, or the server 1308) and performing communication via the established communication channel. The communication module 1390 may include one or more communication processors that are operable independently from the processor 1320 (e.g., the application processor (AP)) and supports a direct (e.g., wired) communication or a wireless communication. In some example embodiments, the communication module 1390 may include a wireless communication module 1392 (e.g., a cellular communication module, a short-range wireless communication module, or a global navigation satellite system (GNSS) communication module) and/or a wired communication module 1394 (e.g., a local area network (LAN) communication module or a power line communication (PLC) module). A corresponding one of these communication modules may communicate with the external electronic device via the first network 1398 (e.g., a short-range communication network, such as Bluetooth^{™}, wireless-fidelity (Wi-Fi) direct, or infrared data association (IrDA)) or the second network 1399 (e.g., a long-range communication network, such as a cellular network, the Internet, or a computer network (e.g., LAN or wide area network (WAN)). These various types of communication modules may be implemented as a single component (e.g., a single chip), or may be implemented as multi-components (e.g., multi-chips) separate from each other. The wireless communication module 1392 may identify and authenticate the electronic device 1301 in a communication network, such as the first network 1398 or the second network 1399, using subscriber information (e.g., international mobile subscriber identity (IMSI)) stored in the subscriber identification module 1396.

The antenna module 1397 may transmit or receive a signal or power to or from the outside (e.g., the external electronic device) of the electronic device 1301. In some example embodiments, the antenna module 1397 may include an antenna including a radiating element composed of a conductive material or a conductive pattern formed in or on a substrate (e.g., PCB). In some example embodiments, the antenna module 1397 may include a plurality of antennas. In some example embodiments, at least one antenna appropriate for a communication scheme used in the communication network, such as the first network 1398 or the second network 1399, may be selected, for example, by the communication module 1390 (e.g., the wireless communication module 1392) from the plurality of antennas. The signal or the power may then be transmitted or received between the communication module 1390 and the external electronic device via the selected at least one antenna. In some example embodiments, another component (e.g., a radio frequency integrated circuit (RFIC)) other than the radiating element may be additionally formed as part of the antenna module 1397.

In some example embodiments, the communication module 1390 may include a transceiver TRX according to example embodiments. A part or all of the processor 1320 may be the processor included in the semiconductor chip according to example embodiments. In some example embodiments, a part or all of the transceiver TRX and the processor 1320 may be implemented as separate chips or as a single chip. The antenna module 1397 may include an antenna connected to the transceiver TRX. Similarly, other electronic devices 1302 and 1304 may also include transceivers, processors, antennas, etc., according to example embodiments. For example, each electronic device may be a user equipment (UE) or a base station.

The example embodiments may be applied to various communication devices and systems, and electronic devices and systems that include the communication devices and systems. For example, the example embodiments may be applied to systems such as a personal computer (PC), a mobile phone, a smart phone, a tablet computer, a laptop computer, a personal digital assistant (PDA), a portable multimedia player (PMP), a digital camera, a portable game console, a music player, a camcorder, a video player, a navigation device, a wearable device, an internet of things (IoT) device, an internet of everything (IoE) device, an e-book reader, a virtual reality (VR) device, an augmented reality (AR) device, a robotic device, a drone, an automobile, other devices or systems that may use a transceiver for communication, etc.

Embodiments are set out in the following Clauses:
Clause 1. A transceiver comprising:
   a first mixer configured to receive first data and a first clock signal, and to generate a first signal to be transmitted to an external device based on the first data and the first clock signal;
   a first amplifier configured to amplify the first signal received from the first mixer;
   a second amplifier configured to amplify a second signal received from the external device;
   an input/output (I/O) port shared by the first amplifier and the second amplifier, and configured to output the amplified first signal and receive the second signal;
   a switch circuit between the first amplifier and the I/O port, and configured to be turned on and off based on a switch control signal; and
   a noise reduction circuit configured to provide the switch control signal to the switch circuit, and
   wherein the noise reduction circuit is configured to output the switch control signal to have an active state during an activation time interval for the first data, and to output the switch control signal to have a deactivated state during a deactivation time interval for the first data.
Clause 2. The transceiver of Clause 1, wherein the switch circuit is configured to be turned on during the activation time interval for the first data, and be turned off during the deactivation time interval for the first data.
Clause 3. The transceiver of Clause 1 or Clause 2,
   wherein the noise reduction circuit is configured to receive an enable signal, and to generate the switch control signal based on the enable signal, and
   wherein the enable signal is in an activated state during the activation time interval for the first data, and is in a deactivated state during the deactivation time interval for the first data.
Clause 4. The transceiver of Clause 3, wherein the noise reduction circuit includes:
   a buffer circuit configured to generate the switch control signal based on the enable signal, and to have characteristics of a low pass filter.
Clause 5. The transceiver of Clause 4,
   wherein the buffer circuit includes a plurality of inverters that are connected in series, and
   wherein a first inverter that is disposed closest to the switch circuit among the plurality of inverters includes:
      a first transistor connected between a power supply voltage and a first node outputting the switch control signal;
      a second transistor connected between the first node and a ground voltage;
      a first resistor connected between a body of the first transistor and the power supply voltage; and
      a second resistor connected between a body of the second transistor and the ground voltage.
Clause 6. The transceiver of Clause 5, wherein the switch circuit includes:
   a third transistor connected between an output of the first amplifier and the I/O port; and
   a third resistor connected between the first node and a gate of the third transistor.
Clause 7. The transceiver of Clause 6,
   wherein a resistance of the first resistor and a resistance of the second resistor are greater than a reference resistance, and
   wherein a resistance of the third resistor is less than the reference resistance.
Clause 8. The transceiver of any of Clauses 4-7, wherein the switch circuit is configured to have characteristics of a high pass filter.
Clause 9. The transceiver of any preceding Clause, wherein the noise reduction circuit is further configured to generate the first clock signal based on the enable signal.
Clause 10. The transceiver of Clause 9, wherein the noise reduction circuit includes:
   an AND gate configured to generate the first clock signal by performing an AND operation on the enable signal and a second clock signal.
Clause 11. A semiconductor chip comprising:
   a processor configured to generate first data to be transmitted to an external device; and
   a transceiver configured to receive the first data, and to operate based on the first data, the transceiver comprising:
      a first mixer configured to generate a first signal based on the first data and a first clock signal;
      a noise reduction circuit configured to provide the first clock signal to the first mixer;
      a first amplifier configured to amplify the first signal received from the first mixer;
      a second amplifier configured to amplify a second signal received from the external device; and
      an input/output (I/O) port shared by the first amplifier and the second amplifier, and configured to output the amplified first signal and receive the second signal, and
   wherein the noise reduction circuit is configured to activate the first clock signal during an activation time interval for the first data, and to deactivate the first clock signal during a deactivation time interval for the first data.
Clause 12. The semiconductor chip of Clause 11, wherein the transceiver further includes:
   a second mixer configured to generate second data based on the amplified second signal and a second clock signal.
Clause 13. The semiconductor chip of Clause 12, wherein the processor is configured to perform data processing on the second data.
Clause 14. A semiconductor chip comprising:
   a processor configured to generate first data to be transmitted to an external device; and
   a transceiver configured to receive the first data, and to operate based on the first data, the transceiver comprising:
      a first mixer configured to generate a first signal based on the first data and a first clock signal;
      a first amplifier configured to amplify the first signal received from the first mixer;
      a second amplifier configured to amplify a second signal received from the external device;
      an input/output (I/O) port shared by the first amplifier and the second amplifier, and configured to output the amplified first signal and receive the second signal;
      a switch circuit between the first amplifier and the I/O port, and configured to be turned on and off based on a switch control signal; and
      a noise reduction circuit configured to provide the switch control signal to the switch circuit,
   wherein the noise reduction circuit is configured to control the switch control signal to be in an active state during an activation time interval for the first data, and to deactivate control the switch control signal to be in an inactive state during a deactivation time interval for the first data.
Clause 15. The semiconductor chip of Clause 14,
   wherein the switch circuit is configured to be turned on in a transmission mode for transmitting the first signal to the external device, and be turned off in a reception mode for receiving the second signal from the external device, and
   wherein, in the transmission mode, the switch circuit is configured to be turned on during the activation time interval for the first data, and be turned off during the deactivation time interval for the first data.
Clause 16. The semiconductor chip of Clause 15, wherein the processor is configured to provide the first data in the transmission mode, and to receive second data in the reception mode.
Clause 17. An electronic device comprising:
   an antenna configured to transmit a first signal to an external device or receive a second signal from the external device;
   a processor configured to generate first data corresponding to the first signal, to generate an enable signal, and to receive second data corresponding to the second signal, the enable signal being activated during an activation time interval for the first data and deactivated during a deactivation time interval for the first data; and
   a transceiver configured to generate the first signal based on the first data and the enable signal, and to generate the second data based on the second signal, the transceiver comprising:
      a noise reduction circuit configured to generate a first clock signal based on the enable signal and a second clock signal, and to generate a switch control signal based on the enable signal;
      a first mixer configured to generate the first signal based on the first data and the first clock signal;
      a power amplifier configured to amplify the first signal;
      a low noise amplifier configured to amplify the second signal;
      a second mixer configured to generate the second data based on the amplified second signal and the second clock signal;
      an input/output (I/O) port shared by the power amplifier and the low noise amplifier, and connected to the antenna; and
      a switch circuit between the first amplifier and the I/O port, and configured to be turned on and off based on the switch control signal.
Clause 18. The electronic device of Clause 17, wherein the processor and the transceiver are included in separate chips.
Clause 19. The electronic device of Clause 17, wherein the processor and the transceiver are included in a single chip.

The foregoing is illustrative of example embodiments and is not to be construed as limiting thereof. Although some example embodiments have been described, those skilled in the art will readily appreciate that many modifications are possible in the example embodiments without materially departing from the novel teachings and advantages of the example embodiments. Accordingly, all such modifications are intended to be included within the scope of the claims. Therefore, it is to be understood that the foregoing is illustrative of various example embodiments and is not to be construed as limited to the specific example embodiments disclosed, and that modifications to the disclosed example embodiments, as well as other example embodiments, are intended to be included within the scope of the appended claims.

## Claims

1. A transceiver comprising:
a first mixer configured to receive first data and a first clock signal, and to generate a first signal to be transmitted to an external device based on the first data and the first clock signal;
a noise reduction circuit configured to provide the first clock signal to the first mixer;
a first amplifier configured to amplify the first signal received from the first mixer;
a second amplifier configured to amplify a second signal received from the external device; and
an input/output, I/O, port shared by the first amplifier and the second amplifier, and configured to output the amplified first signal and receive the second signal,
wherein the noise reduction circuit is configured to activate the first clock signal during an activation time interval for the first data, and to deactivate the first clock signal during a deactivation time interval for the first data.

2. The transceiver of claim 1,
wherein the first clock signal is configured to be toggled during the activation time interval for the first data, and is to be deactivated during the deactivation time interval for the first data, and
wherein the first mixer is configured to be turned on during the activation time interval for the first data, and be turned off during the deactivation time interval for the first data.

3. The transceiver of claim 1 or claim 2,
wherein the noise reduction circuit is configured to receive an enable signal, and to generate the first clock signal based on the enable signal, and
wherein the enable signal is in an activated state during the activation time interval for the first data, and is in a deactivated state during the deactivation time interval for the first data.

4. The transceiver of claim 3, wherein the noise reduction circuit includes:
an AND gate configured to generate the first clock signal by performing an AND operation on the enable signal and a second clock signal.

5. The transceiver of claim 4, wherein the second clock signal is configured to be continually toggled regardless of the enable signal.

6. The transceiver of claim 4 or claim 5, wherein the noise reduction circuit further includes:
a buffer circuit between the AND gate and the first mixer.

7. The transceiver of any preceding claim, further comprising:
a switch circuit between the first amplifier and the I/O port, and configured to be turned on and off based on a switch control signal.

8. The transceiver of claim 7, wherein the noise reduction circuit is configured to further generate the switch control signal based on the enable signal.

9. The transceiver of claim 8, wherein the noise reduction circuit includes:
a buffer circuit configured to generate the switch control signal based on the enable signal, and to have characteristics of a low pass filter.

10. The transceiver of any of claims 7-9, wherein the switch circuit is configured to have characteristics of a high pass filter.

11. A semiconductor chip comprising:
a processor configured to generate first data to be transmitted to an external device; and
a transceiver according to any preceding claim and configured to receive the first data, and to operate based on the first data.

12. The semiconductor chip of claim 11, wherein the transceiver further includes:
a second mixer configured to generate second data based on the amplified second signal and a second clock signal.

13. The semiconductor chip of claim 12, wherein the processor is configured to perform data processing on the second data.

14. An electronic device comprising:
an antenna configured to transmit a first signal to an external device or receive a second signal from the external device;
a processor configured to generate first data corresponding to the first signal, to generate an enable signal, and to receive second data corresponding to the second signal, the enable signal being activated during an activation time interval for the first data and deactivated during a deactivation time interval for the first data; and
a transceiver configured to generate the first signal based on the first data and the enable signal, and to generate the second data based on the second signal, the transceiver comprising:
a noise reduction circuit configured to generate a first clock signal based on the enable signal and a second clock signal, and to generate a switch control signal based on the enable signal;
a first mixer configured to generate the first signal based on the first data and the first clock signal;
a power amplifier configured to amplify the first signal;
a low noise amplifier configured to amplify the second signal;
a second mixer configured to generate the second data based on the amplified second signal and the second clock signal;
an input/output (I/O) port shared by the power amplifier and the low noise amplifier, and connected to the antenna; and
a switch circuit between the first amplifier and the I/O port, and configured to be turned on and off based on the switch control signal.

15. The electronic device of claim 14, wherein the processor and the transceiver are included in separate chips or a single chip.
